# EUROPEAN PATENT APPLICATION

(11) **EP 2 259 671 A1**
(43) Date of publication of application: **08.12.2010**
(21) Application number: 09290416.8
(22) Date of filing: 05.06.2009
(51) Int. Cl.: H05K 7/14

(54) **Optimized ATCA chassis**

(71) Applicant: Alcatel Lucent, 75008 Paris (FR)
(72) Inventor: Stephan, Yannick, 22730 Tregastel (FR)
(74) Representative: Croonenbroek, Thomas Jakob

(57) **Abstract**

The invention concerns a chassis according to the ATCA requirements, adapted for the interconnection of telecommunication circuit boards. The chassis comprises a support structure (2) housing a backplane (9), the backplane having a first set of connectors for the connection of ATCA Mezzanine Cards.

## Description

The present invention relates to chassis for interconnecting circuit boards for the management of telecommunication networks. The invention relates more particularly to chassis designed in compliance with the ATCA standard.

The ATCA (for Advanced Telecommunications Computing Architecture) standards notably define the specifications that chassis manufacturers have to satisfy. A shelf or chassis comprises a support structure in which several slots (usually between 2 and 14) are defined on the front side for receiving circuit boards at the ATCA format, also named blades or Front Boards. The number of slots available allows the user to adapt its configuration to the needs of its applications. An ATCA circuit board includes a PCB and a panel. Each slot is defined by a common board form factor for the insertion of an ATCA board. The support structure houses a backplane for the interconnection of the boards. The backplane notably provides the following interconnections: zone 1 for power, management and other ancillary functions, zone 2 for the data transport interface, and zone 3 (connectivity in zone 3 is optional) for user defined connections. The support structure may also define several slots on the rear side for receiving boards at the RTM (for Rear Transition Module) format. RTM boards are usually directly interconnected to the ATCA boards through zone 3 connectors. Some ATCA boards are designed to optionally receive AMC (For ATCA Mezzanine Card) modules to extend their capacity. An AMC module is directly connected on the ATCA board itself. An ATCA board mainly carries out functions of two different types: access functions and processing functions.

Redundancy can be required for defense aspects. An ATCA board and its associated AMC are handled as a single board for redundancy appraisal. Redundancy is guaranteed by providing at least one spare ATCA board for each function. If a problem is identified on an ATCA board, processing is switched from this board to one spare ATCA board. For keeping a high reliability during the switching, an ATCA board is dedicated to one type of function only. Whatever the number of communication lines, at least one ATCA board is required for carrying out the access functions. An additional ATCA board is required for providing redundancy for these access functions. At least one ATCA board is required for carrying out the processing functions. Several processing functions can be used by an application in a pool mode. At least an additional ATCA board is required for providing redundancy for these processing functions. Thus, the ATCA chassis requires at least four ATCA boards to carry out all the functions and provide a redundancy protection.

These chassis have several drawbacks. These chassis have a number of ATCA slots that are wasted by redundant ATCA boards, which are not permanently in service. This impacts the overall chassis performance and dimensions. Moreover, cost and power dissipation are significantly increased by the redundant ATCA boards. There is thus a need for an ATCA chassis overcoming at least one of these drawbacks.

The invention proposes a chassis according to the ATCA requirements, adapted for the interconnection of telecommunication circuit boards. The chassis comprises a support structure housing a backplane, the backplane having a first set of connectors for the connection of ATCA Mezzanine Cards.

In a further embodiment, the backplane has a second set of connectors for the connection of ATCA boards.

In another embodiment the support structure provides a first set of slots having the ATCA Mezzanine Cards form factor and facing respective connectors of the first set of connectors of the backplane, the support structure further providing a second set of slots having the ATCA board form factor and facing respective connectors of the second set of connectors of the backplane.

The first set of slots and the second set of slots may be located on opposite sides of the support structure.

The support structure may house at least first and second ATCA boards in the second set of slots, the first and second ATCA boards being connected to respective connectors of the second set of connectors, the first ATCA board being dedicated for executing processing functions and the second ATCA board being dedicated for executing processing functions instead of the first ATCA board if a failure is detected for the first ATCA board.

The support structure may house at least first and second ATCA Mezzanine Cards in the first set of slots, the first and second ATCA Mezzanine Cards being connected to respective connectors of the first set of connectors, the first ATCA Mezzanine Card being dedicated for executing access functions and the second ATCA Mezzanine Card being dedicated for executing access functions instead of the first ATCA Mezzanine Card if a failure is detected for the first ATCA Mezzanine Card.

The support structure may house at least third and fourth ATCA Mezzanine Cards in the first set of slots, the third and fourth ATCA Mezzanine Cards being connected to respective connectors of the first set of connectors, the third ATCA Mezzanine Card being dedicated for executing processing functions and the fourth ATCA Mezzanine Card being dedicated for executing processing functions instead of the third ATCA Mezzanine Card if a failure is detected for the third ATCA Mezzanine Card.

The support structure may provide a slot housing a shelf management board connected to the backplane, the shelf management board being adapted for detecting a failure of one of the ATCA Mezzanine Cards, the shelf management board being also adapted for managing a function switching between a failing ATCA Mezzanine Card and a spare ATCA Mezzanine Card.

The advantages of the present invention will become apparent from the following description of one embodiment with reference to the accompanying drawings, in which :
- Figures 1 and 2 are respectively front and rear schematic views of an ATCA chassis according to an embodiment of the invention;
- Figure 3 is a top cross-sectional view of the ATCA chassis of figures 1 and 2;
- Figure 4 is a functional view of different elements of an ATCA chassis.

The invention proposes an ATCA chassis providing a backplane and slots suitable for connection of AMCs directly on the backplane.

Improvements of processing capacities make AMCs suited for carrying out redundancy functions. An AMC uses far less space than an ATCA card. An ATCA card is far too much oversized for most functions. The form factor of AMCs requires less than the quarter of the space occupied by the ATCA form factor. Thus, functions like access functions can be carried out on AMCs, several ATCA slots being thereby freed for other applications. A smaller chassis can be used for a similar capacity. As the AMCs have their own connections on the backplane, their redundancy can be easily and reliably handled independently from ATCA boards. Since the ATCA standard's requirements are met at board level, the development efforts are reduced, providing more time to design the final application.

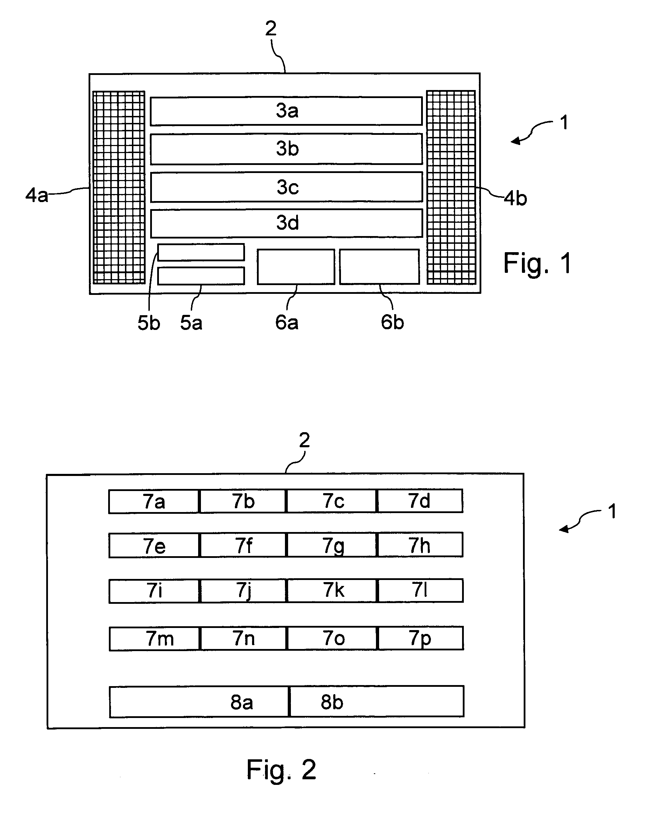

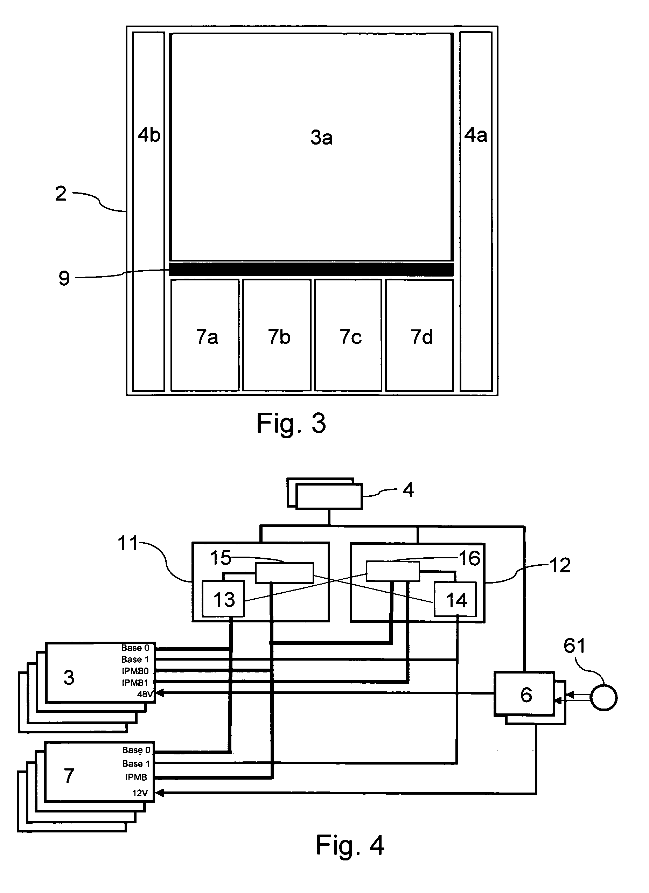

Figure 1 is a front view of a 5U ATCA chassis 1 according to an embodiment of the invention. Figure 2 is a back view of this chassis 1. Figure 3 is a top view of the chassis 1 at the level of a slot.

The chassis 1 includes a support structure 2 usually named Subrack. On the rear side, the support structure 2 provides a first set of adjacent slots 7a-7p having the AMC form factor. As illustrated, the 5U chassis 1 provides 16 slots at the AMC form factor. The support structure 2 also advantageously provides slots 8a and 8b for auxiliary modules (with a custom or AMC standard size). The support structure 2 provides a second set of superposed slots 3a-3d having an ATCA form factor on its front side (notably defined in PICMG3.0 specifications). The support structure 2 also provides slots for the following modules on its front side: slots 5a and 5b are configured to house shelf management boards, slots 6a and 6b are configured to house power supply units, slots 4a and 4b are configured to house fan trays on both sides of slots 3a-3d and 7a-7p. Thus, the chassis 1 can advantageously provide redundancy for shelf management boards, for power supply units and for fan trays. The support structure 2 comprises guide rails at the edges of these slots, ESD discharge clips and alignment/keying hardware.

A backplane 9 is housed inside the support structure 2, between slots 3a-3d and slots 7a-7p. The backplane 9 provides connector interfaces for power distribution as well as input/output connectivity (zone 1, zone 2 and zone 3) for the different boards. The backplane 9 also provides the final mechanical alignment and support for front boards. The backplane 9 comprises a first set of connectors (not illustrated) for the connection of the AMCs. Each connector of the first set faces a respective AMC slot. The backplane 9 also comprises a second set of connectors (not illustrated) for the connection of the ATCA boards. Each connector of the second set faces a respective ATCA slot. The backplane 9 provides at least zone 1 and zone 2, whereas zone 3 connectors are added according to the need of the application for each of these slots. The backplane 9 also provides additional connectors facing the remaining slots. Though the backplane 9 can be split into separate rear and front circuit boards, the backplane 9 is advantageously common for front and rear slots.

Once a shelf management board is inserted in slot 5a or 5b, it is interconnected with ATCA boards housed in slots 3a to 3d or with AMCs housed in slots 7a to 7p. A shelf management board dedicated to the ATCA boards will notably handle the redundancy. In case a failure is detected in an ATCA board, its shelf management board will switch the tasks towards a spare ATCA board. A shelf management board dedicated to the AMCs will notably handle redundancy. In case a failure is detected in an AMC, its shelf management board will switch the tasks towards a spare AMC. A common shelf management board can also manage both the ATCA boards and the AMCs. The shelf management board(s) can be duplicated.

Auxiliary modules allow the user to customize its chassis according to the applications and the communications required between ATCA boards and AMCs for instance. Auxiliary slots can notably receive Ethernet switches, SAS expanders for storage applications...

AMCs will preferably manage the access functions of the chassis 1, whereas the ATCA boards will preferably manage the processing functions (however, access functions can be managed by ATCA boards and processing functions can be managed on AMC as well). A chassis 1 can also be designed with AMCs connected to the backplane and managing both access and processing functions. The overall dimensions of the chassis can thereby be optimized.

Figure 4 is a functional view of various elements of the chassis 1. The chassis 1 houses two shelf management boards 11 and 12, power supply units 6, fan trays 4, ATCA boards 3 and AMCs 7.

The shelf management boards 11 and 12 include respectively controllers 15 and 16 and Ethernet controllers 13 and 14. Ethernet controllers are connected to respective base interfaces of the ATCA boards 3 and of the AMCs 7 and to the controllers 15 and 16. Controllers 15 and 16 are connected to IPM controllers located respectively in the ATCA boards 3 and the AMCs 7 through an IPM bus. Power supply units 6 are advantageously duplicated and can accommodate AC or DC power supply, based on power provided by a primary supply 61. The power supply units 6 supply the ATCA boards with a 48V voltage and supply the AMCs with a 12V voltage.

Originally, AMCs do not provide duplicated power entry interfaces. In order to improve the redundancy management of the AMCs, independent power supply units 6 are coupled. Each supply output of a power supply unit is provided with a current limiter to avoid any failure propagation in the chassis 1. Each shelf management board 11 or 12 can have its own individual electrical protection. The shelf management boards 11 and 12 can be coupled.

A chassis according to the invention can provide another amount of ATCA or AMC slots than described previously. The described embodiment discloses a 1+1 redundancy scheme. However, the invention applies to a 1+n redundancy scheme as well. The chassis can be adapted to implement any suitable kind of redundancy scheme.

## Claims

1. Chassis (1) according to the ATCA requirements, adapted for the interconnection of telecommunication circuit boards, **characterized in that** it comprises a support structure (2) housing a backplane (9), the backplane having a first set of connectors for the connection of ATCA Mezzanine Cards.

2. Chassis (1) according to claim 1, wherein the backplane (9) has a second set of connectors for the connection of ATCA boards.

3. Chassis (1) according to claim 2, wherein the support structure provides a first set of slots (7a-7p) having the ATCA Mezzanine Cards form factor and facing respective connectors of the first set of connectors of the backplane (9), the support structure (2) further providing a second set of slots (3a-3d) having the ATCA board form factor and facing respective connectors of the second set of connectors of the backplane.

4. Chassis (1) according to claim 3, wherein the first set of slots (7a-7p) and the second set of slots (3a-3d) are located on opposite sides of the support structure (2).

5. Chassis according to any one of claims 2 to 4, wherein the support structure (2) houses at least first and second ATCA boards in the second set of slots (3a-3d), the first and second ATCA boards being connected to respective connectors of the second set of connectors, the first ATCA board being dedicated for executing processing functions and the second ATCA board being dedicated for executing processing functions instead of the first ATCA board if a failure is detected for the first ATCA board.

6. Chassis according to any one of the preceding claims, wherein the support structure (2) houses at least first and second ATCA Mezzanine Cards in the first set of slots (7a-7p), the first and second ATCA Mezzanine Cards being connected to respective connectors of the first set of connectors, the first ATCA Mezzanine Card being dedicated for executing access functions and the second ATCA Mezzanine Card being dedicated for executing access functions instead of the first ATCA Mezzanine Card if a failure is detected for the first ATCA Mezzanine Card.

7. Chassis according to claim 6, wherein the support structure (2) houses at least third and fourth ATCA Mezzanine Cards in the first set of slots (7a-7p), the third and fourth ATCA Mezzanine Cards being connected to respective connectors of the first set of connectors, the third ATCA Mezzanine Card being dedicated for executing processing functions and the fourth ATCA Mezzanine Card being dedicated for executing processing functions instead of the third ATCA Mezzanine Card if a failure is detected for the third ATCA Mezzanine Card.

8. Chassis according to claim 6 or 7, wherein the support structure (2) provides a slot housing a shelf management board (11,12) connected to the backplane (9), the shelf management board being adapted for detecting a failure of one of the ATCA Mezzanine Cards (7), the shelf management board being also adapted for managing a function switching between a failing ATCA Mezzanine Card and a spare ATCA Mezzanine Card.
